# EUROPÄISCHE PATENTSCHRIFT

(11) **EP 2 686 695 B1**
(45) Veröffentlichungstag und Bekanntmachung des Hinweises auf die Patenterteilung: **29.04.2015**
(21) Anmeldenummer: 12707258.5
(22) Anmeldetag: 23.02.2012
(51) Int. Cl.: G01R 33/05

(54) **VORRICHTUNG UND VERFAHREN ZUM MESSEN VON MAGNETFELDERN**
APPARATUS AND METHOD FOR MEASURING MAGNETIC FIELDS
DISPOSITIF ET PROCÉDÉ DE MESURE DE CHAMPS MAGNÉTIQUES

(30) Priorität: 18.03.2011 DE 102011005764
(43) Veröffentlichungstag der Anmeldung: 22.01.2014
(73) Patentinhaber: Robert Bosch GmbH, 70442 Stuttgart (DE)
(72) Erfinder: SCHATZ, Frank, 70806 Kornwestheim (DE); FARBER, Paul, 70193 Stuttgart (DE); WEISS, Stefan, 72070 Tuebingen (DE); LAMMEL, Gerhard, 72070 Tuebingen (DE); BENNINI, Fouad, 72762 Reutlingen (DE)
(86) Internationale Anmeldenummer: PCT/EP2012/053037
(87) Internationale Veröffentlichungsnummer: WO 2012/126693

(56) Entgegenhaltungen:
- US-A1- 2008 316 647
- US-A1- 2009 243 609
- ZORLU ET AL: "An orthogonal fluxgate-type magnetic microsensor with electroplated Permalloy core", SENSORS AND ACTUATORS A, ELSEVIER SEQUOIA S.A., LAUSANNE, CH, Bd. 135, Nr. 1, 28. März 2007 (2007-03-28) , Seiten 43-49, XP005928244, ISSN: 0924-4247, DOI: 10.1016/J.SNA.2006.10.005
- KAWAHITO S ET AL: "A fluxgate magnetic sensor with micro-solenoids and electroplated permalloy cores", SENSORS AND ACTUATORS A, ELSEVIER SEQUOIA S.A., LAUSANNE, CH, Bd. 43, Nr. 1-3, 1. Mai 1994 (1994-05-01), Seiten 128-134, XP026615721, ISSN: 0924-4247, DOI: 10.1016/0924-4247(93)00679-X [gefunden am 1994-05-01]

## Beschreibung

Die vorliegende Erfindung betrifft eine Vorrichtung zum Messen eines Magnetfelds mit einem Kern, der ummagnetisierbares Kernmaterial aufweist, und einer Erregerspule zum Ummagnetisieren des Kernmaterials. Die Erfindung betrifft weiterhin ein entsprechendes Verfahren zum Messen eines Magnetfelds.

### Stand der Technik

Es gibt unterschiedliche Vorrichtungen um Magnetfelder zu bestimmen beziehungsweise zu messen. Diese sind unter anderem Hallsensoren, AMR-Sensoren (AMR: Anisotrope Magneto-Resistivität), Feldplatten, Feldspulen, Fluxgatesensoren, GMR-Sensoren (GMR: giant magnetoresistance oder Riesenmagnetowiderstand), TMR-Sensoren (TMR: tunnel magnetoresistance oder magnetischer Tunnelwiderstand) und SQIDS (Superconducting Quantum Interference Device oder Supraleitende Quanteninterferenzeinheit).

Ein sehr einfaches Prinzip, basierend auf einer Spule und einem weichmagnetischen Kern, ist der Fluxgatesensor. Das Messprinzip basiert auf der Ummagnetisierung eines weichmagnetischen Kerns mit Hilfe einer Erregerspule und der Detektion des dabei generierten zeitabhängigen Flusses mit einer Messspule (Pickup-Spule). Die Flussänderung wird dabei bestimmt durch die Magnetisierungskurve des weichmagnetischen Kerns in Abhängigkeit des äußeren Feldes. Je schneller die Ummagnetisierung erfolgt, desto größer ist die Spannung in der Pickup-Spule. Dabei kann die Spannungserhöhung sowohl durch eine steilere Magnetisierungshysterese erzeugt werden (größere Permeabilität) wie auch durch eine Erhöhung der Frequenz der Erregerspule.

Folgene Veröffentlichungen offenbaren einen Fluxgatesensor und dessen Herstellung:
(1) ZORLU ET AL: "An orthogonal fluxgate-type magnetic microsensor with electroplated Permalloy core", SENSORS AND ACTUATORS A, ELSEVIER SEQUOIA S.A., LAUSANNE, CH, Bd. 135, Nr. 1, 28. März 2007 (2007-03-28), Seiten 43-49, XP005928244,
(2) D2 US 2009/243609 A1 (HASUNUMA TAKASHI [JP]), (3) KAWAHITO S ET AL: "A fluxgate magnetic sensor with micro-solenoids and electroplated permalloy cores", SENSORS AND ACTUATORS A, ELSEVIER SEQUOIA S.A., LAUSANNE, CH, Bd. 43, Nr. 1-3, 1. Mai 1994 (1994-05-01), Seiten 128-134, XP026615721, (4) US 2008/316647 A1 (JOISTEN HELENE [FR] ET AL).

J Ein häufig verwendetes Auswerteverfahren ist die Messung der zweiten harmonischen Komponente des Signals in der Pickup-Spule. Diese Komponente entspricht im Wesentlichen dem nichtlinearen Anteil der Übertragungsfunktion, der von der Sättigung des Kerns herrührt. Die Amplitude der zweiten harmonischen Komponente ist dabei proportional zum externen Feld.

Ein solches Verfahren ist z. B. bei Drljaca, P.M. et al. "Low-Power 2-D fully integrated CMOS Fluxgate Magnetometer", IEEE Sensor Journal, Vol.5, Issue 5, Page 909 - 915 (2005) beschrieben. Die Dimensionen der Fluxgate-Kerne sind dabei Länge 1400 µm, Breite 20 µm und Dicke 7 µm). Bei diesem Verfahren muss die Signalform in ihre Fourrierkomponenten zerlegt werden, um die vom externen Feld abhängige zweite harmonische Komponente zu separieren. Dabei ist es wichtig, dass die Amplitude der zweiten Harmonischen deutlich größer ist als das Rauschen des Systems. Diese Amplitude sinkt aber mit dem Volumen des Kernmaterials. Daher ist die Miniaturisierbarkeit begrenzt.

Ein anderes literaturbekanntes Messverfahren (Promotion Walter Heinecke: "Messung von magnetischen Feldern und Felddifferenzen mit Saturationskernsonden nach dem Verfahren mit direkter Zeitverschlüsselung", Braunschweig, 1975) ist es, den Zeitpunkt der Ummagnetisierung anhand des Spannungsausschlages der in einer Pickup-Spule induzierten Spannung zu messen. Dieser Zeitpunkt hängt vom externen Feld ab und ist somit ein Maß für das zu messende Feld.

Zur genauen Messung dieses Zeitpunktes ist es nötig, dass der Spannungspuls aufgrund der Ummagnetisierung eine möglichst steile Anstiegsflanke aufweist. Eine Erhöhung der Frequenz ist nicht hilfreich, da zwar die Anstiegsflanke schmaler wird, aber im gleichen Verhältnis die Verschiebungsweite kleiner, so dass keine Verbesserung der Auflösung erreicht werden kann. Es bleibt nur, die Magnetisierungshysterese durch geeignete Wahl des Materials und des Herstellungsprozesses möglichst steil zu machen.

Für miniaturisierte Fluxgatesensoren sind der Optimierung von Material und Prozess Grenzen gesetzt, da der MEMS-Herstellungsprozess durch seine Randbedingungen wenig Variation zulässt. Außerdem zeigen kurze Fluxgatekerne aufgrund des Entmagnetisierungsfaktors flachere Hysteresekurven als nicht miniaturisierte Fluxgates des gleichen Materials. Weiterhin wird durch die Miniaturisierung der Spulen und des Spulenkerns das Signal an den Pickup-Spulen immer kleiner (bei gleicher Magnetisierungshysterese), sodass die Auswertung immer schwieriger wird.

Aufgabe der Erfindung ist es, eine Messvorrichtung und ein entsprechendes Messverfahren bereitzustellen, das ein Messen kleinster Magnetfelder mit geringem Platzbedarf ermöglicht.

### Offenbarung der Erfindung

Die Aufgabe wird durch eine erfindungsgemäße Vorrichtung gemäß Anspruch 1 gelöst. Das Kernmaterial der erfindungsgemäßen Vorrichtung ist als eine Schicht oder als mehrere zueinander beabstanded angeordnete Schichten ausgebildet. Der Kern weist (a) eine maximale Gesamtausdehnung G mit 2,5 mm ≥ G ≥ 0,2 mm auf, (b) eine Dicke D mit 2 µm ≥ D ≥ 0,2 µm auf und (c) ein Verhältnis von Länge zu Breite auf, das größer oder gleich dem Wert zwanzig ist. Durch diese Bemaßung ergibt sich ein Kern, dessen mindestens eine Schicht als magnetisch anisotrope Schicht ausgebildet ist. Diese magnetisch anisotrope Schicht weist bezüglich der Magnetisierung bevorzugt eine zweizählige Symmetrie (180°-Symmetrie) auf. Diese Vorrichtung wird im folgenden als Flip-Core-Sensor bezeichnet.

Eine derartige Ausgestaltung des Kernmaterials hat den Vorteil, dass eine Ummagnetisierung durch Verschiebung mindestens einer Bloch-Wand erfolgt. Da Bloch-Wandverschiebungen mit einer Geschwindigkeit von etwa 100 m/s stattfinden, kann eine Verschiebung einer Bloch-Wand in einem Kernmaterial mit einer Schicht-Breite von etwa 50 µm in weniger als 0,5 µs erfolgen. Dies hat den Vorteil, dass ein um den Faktor 10 größeres Signal als mit einem im Wesentlichen auf Weiss-Bezirk-Umpolung basierenden Fluxgate-Magnetometer erzielt werden kann. Da die Magnetisierungsänderung im Wesentlichen von der Geschwindigkeit der Verschiebung der Bloch-Wände abhängt, ist die Magnetisierungsänderung des Kernmaterials der erfindungsgemäßen Vorrichtung vorteilhafterweise zudem, zumindest im Wesentlichen, unabhängig von der Frequenz des durch die Erregerspule fließenden Wechselstroms. Ein weiterer Vorteil der erfindungsgemäßen Vorrichtung ist, dass die Vorrichtung stärker miniaturisiert werden kann, da das Signal der erfindungsgemäßen Vorrichtung größer ausfällt.

Kern der Erfindung ist also, die Dimensionen des Kerns 10 so zu optimieren, dass die Ummagnetisierung in einer Zeit erfolgt, die kürzer ist als die Zeit, die man zum Durchlaufen der Magnetisierungskurve benötigt. Der gesamte Ummagnetisierungsvorgang läuft dann in einem Schritt mit der Geschwindigkeit der Domänenwandbewegung ab.

Damit kann man die Dauer des Ummagnetisierungsprozesses auf unter 500 ns beschränken, wodurch eine gute Zeitauflösung des Kompensationspunktes erreicht wird. Damit kann der dazugehörige Anregungsstrom gut bestimmt werden.

Die erfindungsgemäße Vorrichtung kann daher vorteilhafterweise in einen Mikrochip, beispielsweise ein mikroelektromechnisches System (MEMS), integriert werden. Dabei werden unter "mikroelektromechanischen Systemen" insbesondere sowohl mikroelektromechanische Systeme (MEMS) als auch kleinere elektromechanische Systeme, wie nanoelektromechanische Systeme (NEMS), verstanden. Vorzugsweise erstrecken sich die Weiss-Bezirke über die Dicke der Schicht oder Schichten.

Insbesondere ist vorgesehen, dass die Dicke D des Kerns im Bereich 1 µm ≥ D ≥ 0,2 µm liegt.

Gemäß einer bevorzugten Ausgestaltung der Erfindung ist vorgesehen, dass der Kern ein Verhältnis von Länge zu Breite aufweist, das größer oder gleich dem Wert fünfundzwanzig ist.

Gemäß einer bevorzugten Ausführungsform der Erfindung ist vorgesehen, dass das Kernmaterial eine Permeabilitätszahl µᵣ größer oder gleich Fünftausend (5.000), insbesondere größer oder gleich Zehntausend (10.000), aufweist.

Gemäß einer bevorzugten Ausführungsform der Erfindung ist vorgesehen, dass das Kernmaterial des Kerns ein weichmagnetisches Material ist. Insbesondere ist das Kernmaterial des Kerns eine Nickel-Eisen-Legierung (NiFe oder Mu-Metall (µ-Metall, engl. Mu-metal oder permalloy). Mu-Metall ist eine weichmagnetische Nickel-Eisen-Legierung (ca. 75-80 % Nickel) sehr hoher magnetischer Permeabilität (Permeabilitätszahl µᵣ: 50.000...140.000), die zum Beispiel zur Abschirmung niederfrequenter Magnetfelder und zur Herstellung von ferromagnetischen Kernen von Signalübertragern, magnetischen Stromsensoren und Stromwandlern eingesetzt wird.

Gemäß einer weiteren bevorzugten Ausführungsform der Erfindung ist vorgesehen, dass zwischen den Schichten aus ummagnetisierbarem Kernmaterial jeweils eine unmagnetische Zwischenschicht angeordnet ist. Die Zwischenschichten sind bevorzugt so dünn, dass Kristallisation vermieden wird, ohne die Austauschwechselwirkung zwischen den Schichten aus ummagnetisierbarem Kernmaterial zu stören. Besonders bevorzugt ist/sind die unmagnetische(n) Zwischenschicht(en) zwischen einem Nanometer (1 nm) und drei Nanometer (3 nm) dick.

Weiterhin ist bevorzugt vorgesehen, dass die Dicke jeder einzelnen der Schichten aus ummagnetisierbaren Kernmaterial eines Kerns mit mehreren zueinander beabstanded angeordnete Schichten eine Schichtdicke D_{S} mit 60 nm ≥ D_{S} ≥ 20 nm aufweist.

Gemäß einer weiteren bevorzugten Ausführungsform der Erfindung ist vorgesehen, dass die Vorrichtung eine Einrichtung zum Detektieren des Ummagnetisierungsprozesses aufweist. Diese Einrichtung kann eine Ummagnetisierung zum Beispiel mittels magneto-optischer Effekte oder mittels resultierender Streufelder detektieren. Die Einrichtung ist zum Beispiel eine Einrichtung zum Ermitteln des Magnetisierungszustands des Kernmaterials.

Ein weiterer Gegenstand der vorliegenden Erfindung ist ein mikroelektromechanisches System, welches eine erfindungsgemäße Vorrichtung umfasst.

Ein weiterer Gegenstand der vorliegenden Erfindung ist ein Verfahren zum Messen eines Magnetfelds mittels einer vorgenannten Vorrichtung. Im Rahmen des erfindungsgemäßen Verfahrens wird die Erregerspule von einem Wechselstrom zum periodischen Ummagnetisieren des Kernmaterials unter Ausbildung eines periodisch wechselnden Magnetfelds durchflossen, wodurch das Kernmaterial periodisch ummagnetisiert wird. Dabei überlagern sich das zu messende Magnetfeld und das Magnetfeld der Erregerspule. Aus einer zeitlichen Verschiebung der Ummagnetisierung des Kernmaterials bezüglich des Nulldurchgangs des Wechselstroms wird auf das zu messende Magnetfeld geschlossen.

In einer weiteren Ausführungsform der Erfindung weist die Vorrichtung eine Einrichtung zum Detektieren des Ummagnetisierungsprozesses auf. Dabei wird der Zeitpunkt der Ummagnetisierung durch ein auf Bloch-Wand-Verschiebung, insbesondere auf der Verschiebung einer einzigen Bloch-Wand, basierendem Signal bestimmt werden. Dies ist vorteilhaft, da die Verschiebung einer Bloch-Wand in der Regel schneller vor sich geht als die Ummagnetisierung der Weiss-Bezirke, wodurch ein höheres Signal erzeugt wird und dadurch eine genaue Angabe des Zeitpunktes der Ummagnetisierung stattfinden kann.

Gemäß einer weiteren bevorzugten Ausführungsform der Erfindung ist vorgesehen, dass die Einrichtung eine Messspule zum Messen einer durch das Kernmaterial hervorgerufenen Magnetfeldänderung aufweist, wobei der Zeitpunkt der Ummagnetisierung durch eine in der Messspule induzierte Spannungsänderung bestimmt wird. Insbesondere kann der Zeitpunkt der Ummagnetisierung durch einen in der Messspule induzierten, auf Bloch-Wand-Verschiebung, insbesondere auf der Verschiebung einer einzigen Bloch-Wand, basierenden Spannungspuls bestimmt werden. Dies ist vorteilhaft, da die Verschiebung einer Bloch-Wand in der Regel schneller vor sich geht als die Ummagnetisierung der Weiss-Bezirke, wodurch ein höheres Signal erzeugt wird und dadurch eine genaue Angabe des Zeitpunktes der Ummagnetisierung stattfinden kann.

Die Erfindung wird im Folgenden anhand von Abbildungen näher erläutert. Es zeigt
- Figur 1: zwei korrespondierende Graphen zur Illustration des Messprinzips und
- Figur 2: einen Kern einer Vorrichtung zum Messen eines Magnetfelds.

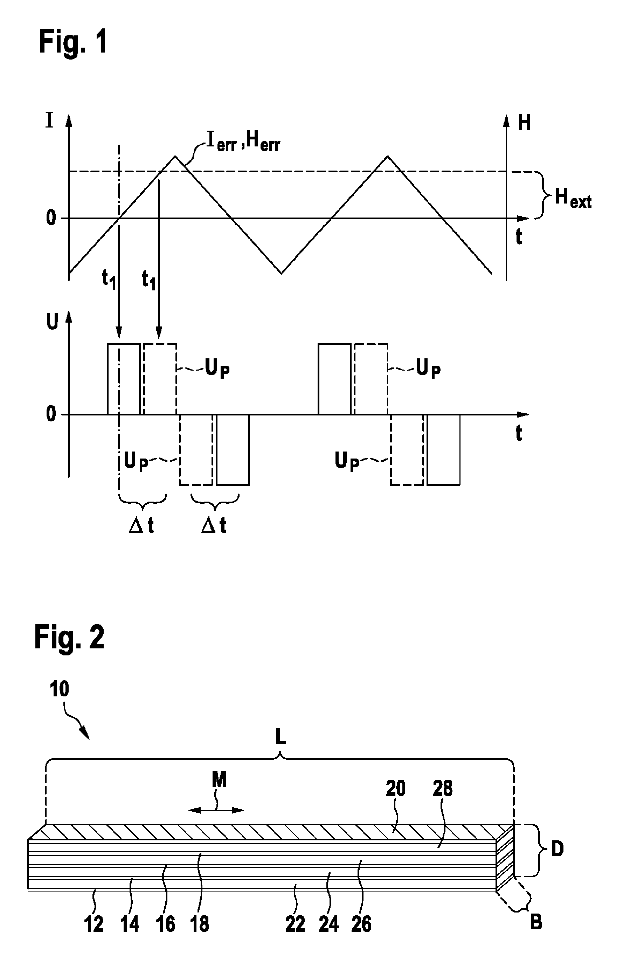

Die Vorrichtung zum Messen eines Magnetfelds weist in einer hier nicht gezeigten Ausführungsform einen in Fig. 2 gezeigten Kern 10, der ummagnetisierbares Kernmaterial in Form von mindestens einer Schicht umfasst, eine Erregerspule zum ummagnetisieren der Schichten dieses Kerns 10 und eine Einrichtung zum zeitabhängigen Detektieren dieses Ummagnetisierungsprozesses auf. Diese Einrichtung weist eine Messspule zum Messen einer durch das ummagnetisierbare Kernmaterial hervorgerufenen Magnetfeldänderung auf.

Figur 1 zeigt zwei korrespondierende Graphen zur Illustration des Messprinzips. Der obere Graph zeigt einen Wechselstrom Iₑᵣᵣ durch die Erregerspule, der über der Zeit t aufgetragen. Dieser Wechselstrom ist direkt proportional zu einer magnetischen Feldstärke H. Der Wechselstrom Iₑᵣᵣ ergibt sich durch eine an die Erregerspule angelegte Wechselspannung, die im gezeigten Beispiel als Dreiecksspannung ausgebildet ist. Weiterhin ist die magnetischen Feldstärke Hₑₓₜ des zu messenden externen Magnetfeldes eingezeichnet.

Der untere Graph der Figur 1 zeigt die resultierende Spannung U über der Zeit t, die an der Messspule der Vorrichtung abgegriffen werden kann. Diese Spannung hat die hier schematisch dargestellte Form von Spannungspulsen Uₚ.

Figur 2 zeigt den Kern 10 einer Vorrichtung zum Messen eines Magnetfelds. Der Kern 10 weist mehrere (hier fünf) planparallel zueinander beabstanded angeordnete Schichten 12, 14, 16 , 18, 20 aus ummagnetisierbarem Kernmaterial und zwischen je zwei benachbarten Schichten 12, 14, 16, 18, 20 angeodneten unmagnetischen Zwischenschichten 22, 24, 26, 28 auf. Der Kern 10 weist dabei eine maximale Gesamtausdehnung G auf, die etwas über G = 1,5 mm liegt, ein Verhältnis von Länge L zu Breite B auf, das gleich dem Wert vierundzwanzig (L:B = 24) ist und eine Dicke D auf, die bei 0,26 µm liegt. Die Länge L jeder der Schichten aus ummagnetisierbarem Material ist dabei 1200 µm, die Breite B jeder der Schichten ist 50 µm. Die Dicke D_{S} jeder der Schichten 12, 14, 16, 18, 20 aus ummagnetisierbarem Material liegt bei 50 nm.

Das ummagnetisierbare Kernmaterial ist eine weichmagnetische Nickel-Eisen-Legierung mit hoher Permeabilität (Permeabilitätszahl µᵣ zum Beispiel 100.000) und geringer Magnetostriktion. Aufgrund der gewählten Geometrie der Schichten 12, 14, 16, 18, 20 und einem passend gewählten Substrat (nicht gezeigt), sind die ummagnetisierbaren Schichten als magnetisch anisotrope Schichten ausgebildet, die bezüglich der Magnetisierungsrichtungen eine zweizählige Symmetrie (180°-Symmetrie) aufweisen (Doppelpfeil M in Fig. 2). Diese Symmetrie ist bei allen Schichten 12, 14, 16, 18, 20 aus ummagnetisierbarem Kernmaterial parallel ausgerichtet.

Es ergibt sich folgende Funktion: Im Rahmen des erfindungsgemäßen Messverfahrens wird die Erregerspule von einem Wechselstrom Iₑᵣᵣ unter Ausbildung eines periodisch wechselnden Magnetfelds Hₑᵣᵣ durchflossen, wodurch das Kernmaterial in den Schichten 12, 14, 16, 18, 20 periodisch ummagnetisiert wird. Dabei überlagern sich das zu messende Magnetfeld Hₑₓₜ und das Magnetfeld der Erregerspule Hₑᵣᵣ. Aus einer zeitlichen Verschiebung der Ummagnetisierung des Kernmaterials bezüglich des Nulldurchgangs des Wechselstroms (Δt) wird auf das zu messende Magnetfeld Hₑₓₜ geschlossen. Dazu wird der Zeitpunkt der Ummagnetisierung durch eine in der Messspule induzierte Spannungsänderung bestimmt. Insbesondere kann der Zeitpunkt der Ummagnetisierung durch einen in der Messspule induzierten, auf Bloch-Wand-Verschiebung, insbesondere auf der Verschiebung einer einzigen Bloch-Wand, basierenden Spannungspuls bestimmt werden. Dies ist vorteilhaft, da die Verschiebung einer Bloch-Wand in der Regel schneller vor sich geht als die Ummagnetisierung der Weiss-Bezirke, wodurch ein höheres Signal erzeugt wird und dadurch eine genaue Angabe des Zeitpunktes der Ummagnetisierung stattfinden kann.

Durch die Verwendung eines hochpermeablen, weichmagnetischen Kernmaterials und die besonders gewählte Geometrie der Schicht/Schichten ergeben sich sehr schmale Spannungspulse, die eine präzise Bestimmung des externen Magnetfeldes erlaubt. Die Erregerspule ist dabei so dimensioniert, dass sie das ummagnetisierbare Kernmaterial im vorgegebenen Messbereich für beide (antiparallel zueinander verlaufende) Magnetisierungsrichtungen in die Sättigungsmagnetisierung +/-Mₛ treiben kann. Diese Sättigungsmagnetisierung liegt für Permalloy bei 0,7 bis 0,8 T Flussdichte. Für das Flip-Core-Verfahren kann jedoch auch Material mit größerer oder kleinerer Sättigungsmagnetisierung genutzt werden.

Die Vorrichtung wird daher auch als Flipcore-(Magnetfeld-)Sensor bezeichnet. Das Grundprinzip dieses Flipcore-Sensors (der im Übrigen genauso einfach aufgebaut ist, wie ein Fluxgate-Sensor) ist es, das zu messende äußere Magnetfeld Hₑₓₜ mittels der Erregerspule zu Kompensieren, während der Kern immer beim Feldnulldurchgang schlagartig ummagnetisiert (flippt) und damit den Feldnulldurchgang anzeigt. Die schlagartige Ummagnetisierung lässt sich leicht durch eine Messspule (Pickupspule) oder einen einfachen Magnetfeldsensor nachweisen, da der Umschlag der Magnetisierung von +Mₛ (Sättigungsmagnetisierung) auf -Mₛ gut detektierbar ist. Der notwendige Strom Iₑᵣᵣ zum Kompensieren des externen Feldes Hₑₓₜ ist dann ein Maß für das äußere Magnetfeld.

Vorteil gegenüber einem Fluxgate-Sensor ist, dass dieser Sensor gut miniaturisiert werden kann. Die Miniaturisierung kommt dem Flip-Prinzip sogar entgegen. Magnetisches Material mit Dimensionen im µm-Bereich oder größer zeigt in der Regel immer eine Vielzahl von Domänen. Da die verschiedenen Domänen nie gleichzeitig ummagnetisieren, ist die Dauer der Ummagnetisierung entsprechend lang. Um eine schlagartige Ummagnetisierung zu ermöglichen muss zum einen eine hochpermeable magnetische Schicht verwendet werden, zum Beispiel NiFe, eventuell auch aus mehreren Schichten 12, 14, 16, 18, 20 aufgebaut mit eventuell unmagnetischen Zwischenschichten 22, 24, 26, 28. Die ummagnetisierbaren Schichten sollte nicht zu dick sein, um nicht mehrere Domänen übereinander zu ermöglichen (Dicke kleiner oder gleich 2 µm oder Dicke kleiner oder gleich 1 µm). Außerdem sollte die Breite des Kerns 10 in Abhängigkeit der Länge ein bestimmtes Maß nicht überschreiten, da sonst das eigene Streufeld die Ummagnetisierung stoppt, bevor der ganze Streifen ummagnetisiert ist. Für eine Kernlänge von 1600 µm bis 2000 µm sollte die Breite ≤ 80 µm bevorzugt sein, für eine Kernlänge von 1000 µm bis 1600 µm sollte die Breite bevorzugt ≤ 50 µm sein, für eine Kernlängen von 700 µm bis 1000 µm bevorzugt ≤ 35 µm. Für Kernlängen unter 700 µm ist die Breite bevorzugt auf unter 22 µm beschränkt.

Durch diese geometrische Vorgabe wird der Ummagnetisierungsprozess im Wesentlichen durch einen Domänensprung erreicht (der für die aktuelle Anwendung besonders bevorzugte Bereich ist 700 µm bis 1600 µm). Damit der Ummagnetisierungsprozess oder -vorgang nicht durch andere Prozesse gestört wird, sollte das Material insbesondere hochpermeabel sein.

## Patentansprüche

1. Vorrichtung zum Messen eines Magnetfelds mit einem Kern (10), der ummagnetisierbares Kernmaterial aufweist, und einer Erregerspule zum Ummagnetisieren des Kernmaterials, wobei das ummagnetisierbare Kernmaterial als eine Schicht oder als mehrere zueinander beabstanded angeordnete Schichten (12, 14, 16, 18, 20) ausgebildet ist und der Kern (10)
- eine maximale Gesamtausdehnung G mit 2,5 mm ≥ G ≥ 0,2 mm aufweist,
- ein Verhältnis von Länge zu Breite aufweist, das größer oder gleich dem Wert zwanzig ist und
- eine Dicke D mit 2 µm ≥ D ≥ 0,2 µm aufweist,
**dadurch gekennzeichnet, dass**
die Dicke jeder einzelnen der Schichten (12, 14, 16, 18, 20) aus ummagnetisierbaren Kernmaterial eines Kerns (10) mit mehreren Schichten (12, 14, 16, 18, 20) eine Schichtdicke D_{S} mit 60 nm ≥ D_{S} ≥ 20 nm aufweist.

2. Vorrichtung nach Anspruch 1, **dadurch gekennzeichnet, dass** das ummagnetisierbare Kernmaterial eine Permeabilitätszahl größer oder gleich Zweitausend, insbesondere größer oder gleich Zehntausend, aufweist.

3. Vorrichtung nach Anspruch 1 oder 2, **dadurch gekennzeichnet, dass** das ummagnetisierbare Kernmaterial des Kerns (10) ein weichmagnetisches Material ist.

4. Vorrichtung nach einem der Ansprüche 1 bis 3, **dadurch gekennzeichnet, dass** das ummagnetisierbare Kernmaterial des Kerns (10) eine Nickel-Eisen-Legierung ist.

5. Vorrichtung nach einem der Ansprüche 1 bis 4, **dadurch gekennzeichnet, dass** zwischen den Schichten aus ummagnetisierbarem Kernmaterial jeweils eine unmagnetische Zwischenschicht (22, 24, 26, 28) angeordnet ist.

6. Vorrichtung nach einem der Ansprüche 1 bis 5, **gekennzeichnet durch** eine Einrichtung zum Detektieren des Ummagnetisierungsprozesses.

7. Mikroelektromechanisches System, umfassend eine Vorrichtung nach einem der Ansprüche 1 bis 6.

8. Verfahren zum Messen eines Magnetfelds mittels einer Vorrichtung nach einem der Ansprüche 1 bis 6,
wobei die Erregerspule von einem Wechselstrom zum periodischen ummagnetisieren des Kernmaterials unter Ausbildung eines periodisch wechselnden Magnetfelds durchflossen wird,
wobei sich das zu messende Magnetfeld und das Magnetfeld der Erregerspule überlagern und aus einer zeitlichen Verschiebung der Ummagnetisierung des Kernmaterials bezüglich des Nulldurchgangs des Wechselsstroms auf das zu messende Magnetfeld geschlossen wird.

9. Verfahren nach Anspruch 8, **dadurch gekennzeichnet, dass** die Vorrichtung eine Einrichtung zum Detektieren des Ummagnetisierungsprozesses aufweist.

10. Verfahren nach Anspruch 8 oder 9, **dadurch gekennzeichnet, dass** die Einrichtung eine Messspule zum Messen einer durch das ummagnetisierbare Kernmaterial hervorgerufenen Magnetfeldänderung aufweist, wobei der Zeitpunkt der Ummagnetisierung durch eine in der Messspule induzierte Spannungsänderung, insbesondere einen Spannungspuls, bestimmt wird.

## Claims

1. Apparatus for measuring a magnetic field, with a core (10), which comprises remagnetizable core material, and an exciter coil for remagnetizing the core material, wherein the remagnetizable core material is formed as a layer or as multiple layers (12, 14, 16, 18, 20) disposed at a distance from one another and the core (10)
- has a maximum total extent G where 2.5 mm ≥ G ≥ 0.2 mm,
- has a ratio of length to width that is greater than or equal to a value of twenty, and
- has a thickness D where 2 µm ≥ D ≥ 0.2 µm,
**characterized in that**
the thickness of each individual one of the layers (12, 14, 16, 18, 20) of remagnetizable core material of a core (10) with multiple layers (12, 14, 16, 18, 20) has a layer thickness D_{S} where 60 nm ≥ D_{S} ≥ 20 nm.

2. Apparatus according to Claim 1, **characterized in that** the remagnetizable core material has a permeability index greater than or equal to two thousand, in particular greater than or equal to ten thousand.

3. Apparatus according to Claim 1 or 2, **characterized in that** the remagnetizable core material of the core (10) is a magnetically soft material.

4. Apparatus according to one of Claims 1 to 3, **characterized in that** the remagnetizable core material of the core (10) is a nickel-iron alloy.

5. Apparatus according to one of Claims 1 to 4, **characterized in that** a non-magnetic intermediate layer (22, 24, 26, 28) is respectively disposed between the layers of remagnetizable core material.

6. Apparatus according to one of Claims 1 to 5, **characterized by** a device for detecting the remagnetization process.

7. Microelectromechanical system, comprising an apparatus according to one of Claims 1 to 6.

8. Method for measuring a magnetic field by means of an apparatus according to one of Claims 1 to 6,
wherein the exciter coil is flowed through by an alternating current for the periodic remagnetization of the core material, accompanied by formation of a periodically changing magnetic field,
wherein the magnetic field to be measured and the magnetic field of the exciter coil are superimposed and the magnetic field to be measured is deduced from a time shift of the remagnetization of the core material with respect to the zero crossing of the alternating current.

9. Method according to Claim 8, **characterized in that** the apparatus has a device for detecting the remagnetization process.

10. Method according to Claim 8 or 9, **characterized in that** the device has a measuring coil for measuring a magnetic field change brought about by the remagnetizable core material, wherein the point in time of the remagnetization is determined by a voltage change, in particular a voltage pulse, induced in the measuring coil.

## Revendications

1. Dispositif destiné à mesurer un champ magnétique, comportant un noyau (10) qui comprend un matériau de noyau à magnétisation réversible, et une bobine d'excitation destinée à inverser la magnétisation du matériau du noyau, dans lequel le matériau de noyau à magnétisation réversible est réalisé sous la forme d'une couche ou d'une pluralité de couches (12, 14, 16, 18, 20) disposées de manière espacée les unes des autres, et le noyau (10)
- présente un allongement total G, avec 2,5 mm ≥ G ≥ 0,2 mm,
- présente un rapport de la longueur à la largeur qui est supérieur ou égal à la valeur vingt et
- présente une épaisseur D, avec 2 µm ≥ D ≥ 0,2 µm,
**caractérisé en ce que**
l'épaisseur de chacune des couches individuelles (12, 14, 16, 18, 20) constituées de matériau à magnétisation réversible d'un noyau (10) comportant une pluralité de couches (12, 14, 16, 18, 20) présente une épaisseur de couche Dₛ, avec 60 nm ≥ Dₛ ≥ 20 nm.

2. Dispositif selon la revendication 1, **caractérisé en ce que** le matériau de noyau à magnétisation réversible présente une perméabilité relative supérieure ou égale à deux mille, et plus particulièrement, supérieure ou égale à dix mille.

3. Dispositif selon la revendication 1 ou 2, **caractérisé en ce que** le matériau de noyau à magnétisation réversible du noyau (10) est un matériau magnétique doux.

4. Dispositif selon l'une quelconque des revendications 1 à 3, **caractérisé en ce que** le matériau de noyau à magnétisation réversible du noyau (10) est un alliage de nickel-fer.

5. Dispositif selon l'une quelconque des revendications 1 à 4, **caractérisé en ce qu'**une couche intermédiaire non magnétique (22, 24, 26, 28) est respectivement disposée entre les couches constituées de matériau de noyau à magnétisation réversible.

6. Dispositif selon l'une quelconque des revendications 1 à 5, **caractérisé par** un dispositif destiné à détecter le processus d'inversion de magnétisation.

7. Système micro-électromécanique, comprenant un dispositif selon l'une quelconque des revendications 1 à 6.

8. Procédé de mesure d'un champ magnétique au moyen d'un dispositif selon l'une quelconque des revendications 1 à 6,
dans lequel la bobine d'excitation est traversée par un courant alternatif destiné à inverser périodiquement la magnétisation du matériau de noyau en formant un champ magnétique alternant périodiquement,
dans lequel le champ magnétique à mesurer et le champ magnétique de la bobine d'excitation se superposent et dans lequel le champ magnétique à mesurer peut être estimé à partir d'un décalage temporel de l'inversion de magnétisation du matériau de noyau par rapport au passage à zéro du courant alternatif.

9. Procédé selon la revendication 8, **caractérisé en ce que** le dispositif comprend un moyen destiné à détecter le processus d'inversion de magnétisation.

10. Procédé selon la revendication 8 ou 9, **caractérisé en ce que** le dispositif comprend une bobine de mesure destinée à mesurer une variation de champ magnétique se produisant à travers le matériau de noyau à magnétisation réversible, dans lequel l'instant de l'inversion de magnétisation est déterminé par une variation de tension induite dans la bobine de mesure, et plus particulièrement, par une impulsion de tension.
